# EUROPEAN PATENT APPLICATION

(11) **EP 3 228 675 A1**
(43) Date of publication of application: **11.10.2017**
(21) Application number: 17163910.7
(22) Date of filing: 30.03.2017
(51) Int. Cl.: C09J 7/02

(54) **A SCREEN PROTECTOR FOR A MOBILE ELECTRONIC DEVICE WITH A TOUCH SCREEN**

(30) Priority: 04.04.2016 GB 201605758
(71) Applicant: Tech 21 Licensing Limited, Twickenham, Middlesex TW1 3DY (GB)
(72) Inventor: ROBERTS, Jason, Twickenham, Middlesex TW1 1QX (GB); MARSCHALL, Wilhelm, East Twickenham, TW1 2QD (GB); THORPE, Benjamin, Uxbridge, Middlesex UB8 2PH (GB)
(74) Representative: Boult Wade Tennant

(57) **Abstract**

A screen protector (5) for a mobile electronic device with a touch screen. The screen protector comprises a flat laminated film comprising a layer (2) of polyethylene terephthalate (PET) bonded to one face of a layer (3) of thermoplastic urethane (TPU) and a layer (4) of adhesive on the opposite side of the TPU layer. The PET layer is less than 50µm thick and wherein the adhesive layer provides a tack force of greater than 5 g/cm². The relatively thin layer of PET with the relatively high tack force adhesive provides a screen protector particularly suited to a device with a curved screen.

## Description

The present invention relates to a screen protector for a mobile electronic device with a touch screen.

A recent development in such devices is the Samsung Galaxy S6 Edge+ (RTM), a device with a glass front face which is curved along its two front side edges. The screen extends all the way across the device such that the two side edges of the screen follow the curvature of the glass and the screen itself is curved. This maximises the screen size for a given device size. The presence of the touch screen at the edge of the device also provides novel and versatile ways of interacting with the device.

While such a curved edge screen provides the above benefits for the user, it provides technical challenges for the manufacturers of screen protectors. They are typically manufactured as flat laminated films cut from a larger sheet. However, such sheets are flat and are therefore not well suited to the curved edges of the above device. Also, a user is intended to interact with such a device by sliding their thumb or fingers over the edge of the device to operate the functional features built into the edge of the touch screen. Such a motion will tend to peel any film terminating at the edge of the screen away from the screen at this point. Thus, not only must the screen protector adhere to the device in a region where the geometry of the device is awkward, but it must also be able to resist this peeling.

One attempt to address these challenges has been made by Spigen in their "Curved Crystal" screen protector. This is a screen protector which is formed with pre-curved edges to conform to the shape of the device. Such a screen protector requires a heat treatment step once the film has been cut from the sheet thereby adding expense to the manufacturing process. Further, a material such as thermoplastic urethane (TPU) will become discoloured if subjected to such a heat treatment such that this manufacturing process limits the materials which can be used.

A second approach to this problem again from Spigen is the "Flex HD" screen. This is a sheet of TPU and an adhesive. The use of TPU means that the film is highly flexible and is therefore able to be curved by a user during the application process around the curved edges of the screen. However, this high flexibility comes at a price as the TPU layer is soft and is therefore susceptible to being scratched. Further, while TPU is good at absorbing impact, it is not good at dissipating such an impact and has poor scratch resistance.

According to the present invention there is provided a screen protector for a mobile electronic device with a touch screen, the screen protector comprising a flat laminated film comprising a layer of polyethylene terephthalate (PET) bonded to one face of a layer of thermoplastic urethane (TPU) and a layer of adhesive on the opposite side of the TPU layer; wherein the PET layer is less than 50µm thick and wherein the adhesive layer provides a tack force of greater than 5 g/cm².

The present invention is able to provide a screen protector for a mobile electronic device which is suitable for use with a device with a screen with curved edges. The protector can be applied easily, is scratch resistant and provides a high degree of protection not available in the prior art. This is because of the incorporation of a PET layer which is harder than the TPU. This is more scratch resistant and works effectively in combination with the TPU. The harder PET layer dissipates the impact across a wider area of the TPU which then absorbs this dissipated impact. The layer of PET is thinner than in PET layers which are known from conventional flat screen protectors. This ensures a more flexible film and reduces the tendency of the film to pull itself away from the curved edges and return to its planar state. The use of an adhesive with a high tack force which is more than five times larger than the adhesive used in a traditional screen protector ensures a firm bond at the edges even when a user slides their thumb or fingers over the edge. The PET layer also allows for the provision of coating treatments such as anti-glare, privacy, tinting, anti-finger print, self heating, anti-scratch coatings.

Because the protector is manufactured as a flat sheet, it does not require a heat forming step such that the screen protector can include a TPU layer. This allows it to be produced more cheaply and quickly and provide greater impact protection that the above-mentioned Curved Crystal protector.

For the avoidance of doubt, the requirement for the protector to be a flat laminated film means that the screen protector as provided to the user is flat in the sense that it has been cut directly from a sheet and has not been subjected to any form of heat and/or pressure treatment to permanently curve the film. Only in use are the edges of the screen protector deflected from flat as they are adhered to the curved edges of the screen in the installation process. The Curved Crystal protector is not a flat laminated film as it is curved at the edges, but the Flex HD protector is a flat laminated film.

The PET layer may preferably be less than 40µm thick. It is also preferably less than half, and more preferably less than a third of the thickness of the TPU layer and preferably less than a quarter of the thickness of the TPU layer.

The PET layer may be less than twice the thickness of the adhesive layer and is preferably less than 1.5 times the thickness of the adhesive layer and most preferably less than the thickness of the adhesive layer.

With the thinner PET layer, the TPU typically form a greater proportion of the film thickness such that the thickness of the TPU is preferably greater than two thirds of the total film thickness.

The overall thickness of the film can be reduced such that it is preferably less than 250 µm and is preferably less than 220 µm. The PET layer may be coated with an anti-glare, anti-scratch or self-healing coating as is known in the art in order to enhance the performance of the screen protector. Any such coating should be taken into account when determining the total thickness of the film as referred to above.

The tack force is preferably greater than 6g/cm² and is more preferably greater than 7g/cm².

The screen protector may comprise a further PET layer between the TPU layer and the adhesive.

The screen protector is preferably provided to the user between a pair of release layers removably attached to either side of the flat laminated film. A first release layer removable to expose the layer of adhesive prior to application of the protector to the device, while a second release layer is removable once the protector has been applied to the device such that it protects it during transportation and installation. Because the film is flat, the release layers can both also be flat, again keeping manufacturing costs to a minimum.

The present invention also extends to a method of applying a screen protector according to the first aspect of the present invention, the method comprising laying the laminated film onto the screen of the device to bring the adhesive layer into contact with the screen and bending the edges of the film over the edges of the screen and adhering them in place.

The present invention also extends to a combination of a mobile electronic device with a touch screen which is curved along its longitudinal edges in combination with a screen protector according to a first aspect of the present invention adhered to the touch screen including the curved regions.

An example of a screen protector in accordance with the present invention will now be described with reference to the accompanying drawings, in which:
Fig. 1 is a schematic diagram of the screen protector of the prior art;
Fig. 2 is a similar view of a screen protector of the present invention;
Figs. 3A and 3B are schematic end views showing the application process of the screen protector onto the mobile electronic device; and
Fig. 4 is a schematic cross-section showing the protector between two release layers.

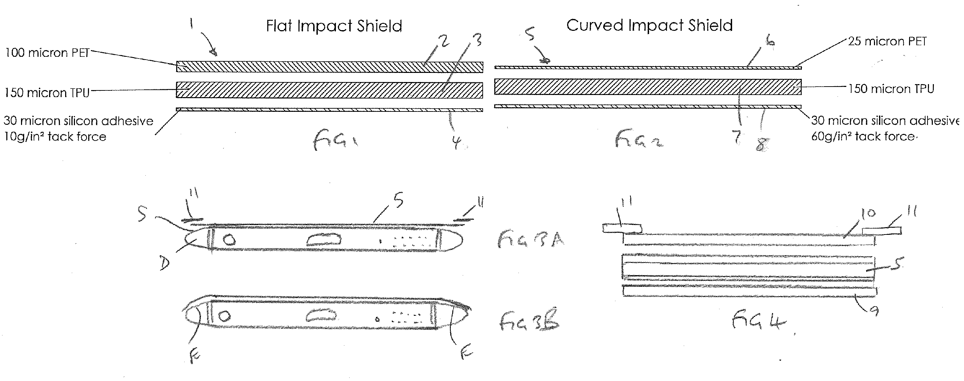

Fig. 1 shows the screen protector currently marketed by the applicant as the Impact Shield screen protector. This screen protector is a laminate of three primary layers, namely an upper layer of PET 100 µm thick, a central layer of TPU (known as BulletShield (RTM)) 150 µm thick and a bottom layer of silicon adhesive 30 µm thick. This adhesive has a tack force of 1.5g/cm² (10g/inch²). The PET and TPU layers are bonded with an adhesive. Optional anti-glare, scratch-resistant and self-healing coatings are applied to the top of the PET. The overall thickness of the screen protector is 280 µm.

Fig. 2 shows a corresponding view of the screen protector according to the present invention. This uses the same TPU layer, but the PET layer has been reduced to 25% of its original thickness such that it is now 25 µm thick. The same thickness of adhesive is used, but this has been substituted with a much stronger adhesive which has a tack force of 9.3g/cm² (60g/inch²). The screen protector is made using the same technique as before just using a reduced thickness of PET and the different adhesive. This means that the screen protectors can be quickly and cheaply produced by cutting them from a sheet of laminate. No subsequent shaping of the sheet is then required.

As previously described, the screen protector may have adhesive between the PET and TPU layers and many of the previously described coatings.

As shown in Fig. 4, the screen protector 5 is supplied to a user sandwiched between two release layers 9 and 10 both of which have a conventional construction. The lower layer 9 is adhered to the adhesive layer 8 and is removed first by a user before applying the protector to a mobile electronic device D as shown in Fig. 3A. The upper release layer is provided with a pair of tabs 11, one on either side of the release layer which enable the user to handle the screen protector for accurate placing on the screen of the device.

Prior to application, the screen may be cleaned with water and a detergent or with alcohol to remove stains and grease from the screen.

The screen protector 5 is initially placed flat on the screen of the device D and may, at that point, be scraped in order to remove any bubbles. Alternatively, this may be done later. The two side edges of the screen protector are then pressed onto the curved edges E of the screen S in a position shown in Fig. 3B. Again, bubbles may be pushed out at this stage. From a comparison of Figs. 1 and 2, the degree to which the PET layer in the vicinity of the edges generates an "unpeeling" is greatly reduced. This is because the PET is relatively stiff. A thick layer when bent out of the neutral plane will generate a higher restoring force than a thinner one.

It will be appreciated from Fig. 3B, the present invention provides a layer of strong adhesive providing a strong bond between the screen protector 5 and the screen S in the regions where it is needed most. It will be appreciated from Fig. 3B that the motion of a thumb or finger around the edge of the device will tend to cause a peeling action on the edge of the screen protector and this is strongly resisted by the screen protector of the present invention.

## Claims

1. A screen protector for a mobile electronic device with a touch screen, the screen protector comprising a flat laminated film comprising a layer of polyethylene terephthalate (PET) bonded to one face of a layer of thermoplastic urethane (TPU) and a layer of adhesive on the opposite side of the TPU layer; wherein the PET layer is less than 50µm thick and wherein the adhesive layer provides a tack force of greater than 5 g/cm².

2. A screen protector according to claim 1, wherein the PET layer is less than 40µm thick.

3. A screen protector according to claim 1 or claim 2, wherein the PET layer is less than a half of the thickness of the TPU layer.

4. A screen protector according to claim 2, wherein the PET layer is less than a third of the thickness of the TPU layer.

5. A screen protector according to any preceding claim, wherein the PET layer is less than twice the thickness of the adhesive layer and is preferably less than 1.5 times the thickness of the adhesive layer and most preferably less than the thickness of the adhesive layer.

6. A screen protector according to any one of the preceding claims, wherein the thickness of the TPU is greater than two thirds of the total film thickness.

7. A screen protector according to any one of the preceding claims, wherein the film thickness is less than 250 µm and is preferably less than 220 µm.

8. A screen protector according to any one of the preceding claims, wherein the tack force is greater than 6g/cm² and is more preferably greater than 7g/cm².

9. A screen protector according to any one of the preceding claims further comprising a second PET layer beween the TPU layer and the adhesive.

10. A combination of a screen protector according to any one of the preceding claims, a first release layer removable to expose the layer of adhesive prior to application of the protector to the device, and a second release layer is removable to expose the top surface of the screen protector once the protector has been applied to the device such that it protects it during transportation and installation.

11. A method of applying a screen protector according to any of claims 1 to 9 the method comprising laying the laminated film onto the screen of the device to bring the adhesive layer into contact with the screen and bending the edges of the film over the edges of the screen and adhering them in place.

12. A combination of a mobile electronic device with a touch screen which is curved along its longitudinal edges and a screen protector according to any of claims 1 to 9 adhered to the touch screen including the curved edges.
